Europäisches Patentamt

European Patent Office

Office européen des brevets

(11) Publication number: **0 427 220 A2**

# EUROPEAN PATENT APPLICATION

(21) Application number: 90121264.7

(22) Date of filing: 07.11.90

(51) Int. Cl.5: **G03C 1/725**, G03C 5/58, H05K 3/10

(30) Priority: 08.11.89 US 434864

(43) Date of publication of application:
15.05.91 Bulletin 91/20

(84) Designated Contracting States:
CH DE FR GB IT LI NL SE

(71) Applicant: **E.I. DU PONT DE NEMOURS AND COMPANY**
1007 Market Street
Wilmington Delaware 19898(US)

(72) Inventor: **Reinbold, Carl William**
309 1/2 Mathis Avenue
Wilmington, Delaware 19804(US)

(74) Representative: Werner, Hans-Karsten, Dr. et al
Patentanwälte von Kreisler-Selting-Werner
Schönwald-Fues-Dallmeyer Hilleringmann,
Deichmannhaus
W-5000 Köln 1(DE)

(54) Copper halide imaging system for electronic applications.

(57) A highly photosensitive element made from fine particles of highly purified copper halide is described. These purified particles may be made by ball-milling an aqueous slurry of relatively insoluble copper halide and then decanting and washing said particles, or be dissolution in an acidic solution of acetonitrile and recovering the particles of pure copper halide therefrom. Elements made using the material of this invention are suitable for the preparation of printed circuits, for example.

EP 0 427 220 A2

# COPPER HALIDE IMAGING SYSTEM FOR ELECTRONIC APPLICATIONS

## BACKGROUND OF THE INVENTION

### 1. Field of the Invention:

This invention relates to novel processes for preparing copper imaging systems and to photosensitive imaging systems prepared therefrom. More particularly, this invention relates to electronic-type elements made using the aforementioned photosensitive system.

### 2. Description of the Prior Art:

Copper is a well-known element used in the fabrication of electronic parts and the like. Conventionally, copper is plated on a surface and some sort of imaging system such as photosensitive polymers and the like, applied supra thereto. This photosensitive element is then exposed through a master tracing of the desired circuitry and the element is developed by wash-out or other conventional methods. This wash-out exposes the copper bearing layer which can then be etched to produce the requisite circuitry. Drawbacks to this particular system include a myriad of things such as undercutting of the image, poor resolution, etc. Thus, there is a need to improve the art of printed circuits and the like. Photosensitive copper pastes have also been described in the prior art. These are applied to the desired surface, imaged, washed, dried and fired to form a hard, copper trace. This system is cumbersome and does not always function in the desired manner, thus producing poor image quality. Additionally, when it is desired to make innerlayer circuits employing prior art elements, useful results are not always achieved. Photosenitive copper elements are also known in the prior art. However, the images produced using these elements can not be amplified and thus the image is often faint or has poor resoution and the like. Consequently, copper imaging systems usually rely on combinations with silver halide elements or are used in diffusion transfer systems.

## SUMMARY OF THE INVENTION

There is a pressing need to prepare elements which are useful in the printed circuit industry. Since copper is a readily available and relatively inexpensive conductor, it is desired to make these elements from this source. Additionally, there is a pressing need to prepare printed circuit elements and the like with good line resolution and which can be readily plated to increase the copper loading thereon. These and yet other needs are achieved in a process for preparing highly photosensitive, purified copper halide from crude halide material by the steps of: a) aqueous ball-milling of said crude copper halide in the presence of 1-5% by weight of an acid or 1-10% by weight stannous chloride on a percentage basis of the crude copper halide to obtain a slurry or fine, uniform particles, decanting and washing said particles to remove impurities therefrom followed removing said water and drying said particles; or, b) dissolving said crude copper halide in acetonitrile in the presence of 1-10% by weight of an acid or stannous chloride on a percentage basis of the crude copper halide and recovering fine particles or pure copper halide therefrom;
followed by sensitizing said copper halide particles made according to a) or b) by contacting said particles with ammonia.

## DETAILS OF THE INVENTION

As previously mentioned, it is well-known that certain copper salts, especially copper halides, are somewhat photosensitive. The prior art reports many instances of using these salts in a photographic elements. However, the photosensitivity is not as great as, for example, silver halide and the prior art has strained to increase the copper salt sensitivity by varying methods. The use of copper in the printed circuit industry is also well-known, since copper is a good conductor and relatively inexpensive. In the practice of this invention, crude copper halide is purified by one of several procedures. In the first procedure, the crude copper halide is ball-milled in an aqueous medium in the presence of 1-5% by weight of an acid (prefer (HCl) or 1-10% by weight of stannous chloride to obtain a fine slurry of small particles of fairly uniform particule size. This slurry is then decanted and washed with water to remove impurities. After drying the copper halide particles may be dispersed in a binder of re-slurried in water and then coated. The particles or the coating may be sensitized with $NH_4OH$ fumes, for example. At this point, these materials are highly photosensitive and can be exposed, developed, washed and dried to form a suitable image. Since this image is mainly copper, it can be plated using conventional techniques such as electroless or electrolytic plating systems, for example. The coatings may be made on any suitable substrate for the use desired. In electronic circuitry, for example, this substrate may be glass, polyimides, etc., used together with a suitable adhesive or suitable film support that may serve as both adhesive and substrate. Alternatively, the produced particles made by this process may be sprayed or dusted on an adhesive layer with no binder present. Sensitization of this layer with $HN_4OH$ fumes, for example, may occur after the particles have been applied to the support. In yet another embodiment, crude copper halide crystals may be dissolved in acetonitrile containing 1-10% by weight of an acide (formic acid is preferred). The copper halide crystals are then recovered by the addition of water or methanol followed by rotary evaporation of the water or methanolic/acetonitrile mixture to yield a fine, white powder of said copper salt. Alternative to this step, the copper halide particles dissolved in acetonitrile may be recovered by the addition of an aromatic organic solvent such as toluene which precipitates a fine, uniform particle size copper halide. The particles obtained by either rotary evaporation or precipitation are then washed to remove impurities. I prefer washing with methanol, for example. These particles are then dried. The powders made per the above may also be dispersed in a suitable binder or coated as an aqueous slurry and sensitized as described above to produce a photosensitive element. In both procedures, it is important to obtain a fine, uniform particle size in order to insure the purity of the copper halide. When this material is coated and sensitized, one may obtain a photosensitive element that may be subsequently imaged and plated-up with additional copper. As previously stated, the copper halide powder, made either by milling (e.g., ball-milling, for example) or by dissolution of crude material in acetonitrile followed by extraction therefrom, can be mixed in a suitable binder or coated as an aqueous or organic slurry of the powder itself prior to coating on a suitable support. The number of binders conventionally used in the photographic industry, are legion in number. Polyvinyl alcohol, which is miscible in water and in which the purified, copper halide powder is eminently compatible may be mentioned. Other binders (e.g., polyvinyl butyral, gelatin, etc.) may, of course, be used if the binder selected is compatible with the copper halide and the system in which the photosensitive layer is to be used. A particularly useful polyvinyl alcohol is Elvanol® which is sold by E. I. du Pont de Nemours & Co., Wilmington, DE. This is usually mixed into water to yield a 3-15% solution thereof. Crude copper halides from any source may be used. The halide may be any of the conventional halides (e.g., chloride, bromide, iodide, etc., or mixtures thereof). I prefer copper chloride (CuCl). Since my novel system induces the purity and fine particle size, copper halide of just about any purity may be used as the starting material. However, I prefer so-called reagent or technical grade material so as to limit the level of impurity present therein. These impurities are usually other copper salts species (e.g., $CuCl_2$, for example). Coating of the copper halide in a binder or as a powder or slurry may be accomplished by any of the conventional methods of coating. The coatings are usually dried and then sensitized by contacting the surface with funes of $NH_4OH$, for example. Directly after sensitization, the coatings may be given an image-wise exposure to ultraviolet light, for example. I prefer a 50-100 millijoule exposure. The exposed element is then developed in a developer comprising ca. 20% aqueous ammonium citrate (pH 7.0), for example, and the resulting imaged fixed by immersial in a ca. 25% Du Pont D-1100X Developer (aqueous ethanol amine/carbitol/KOH) solution, for example. A high quality, copper image is thus obtained. This copper surface may be plated with copper or nickel, for example, using conventional techniques. Thus, it is possible to build-up metal on the image formed in the copper layer. These images of high quality and eminently suitable for electronic applications, for example. Such process of utilizing the photosensitive coating on a support involves imagewise exposure of the coating to actinic radiation wherein the coating is hardened or insolubilized in areas exposed to such radiation. The coating is developed and fixed in a known manner and the imaged coating can be enhanced by application of a conductive material such as by electroless application. This invention will now be illustrated by the following examples, of which Example 1 is considered to be the best mode.

## EXAMPLE 1

Fine, light sensitive cuprous chloride is made by dissolving 1 g of stannous chloride in 100 ml of reagent grade acetonitrile, at a temperature of 100-105° F. The stannous chloride is slowing added to the warm solution, with stirring. When the stannous chloride is dissolved, 10 g of technical grade CuCl is added slowly with stirring. As the CuCl dissolves, it may form a clear, lightly tinted solution, or it may be dark depending on the amount of air ($O_2$) or stannous chloride present. Once the solids are all dissolved, the resulting solution is added to 200 ml reagent grade methanol, (deionized water may be used in place of methanol). The resulting mixture, which may already contain some fine particles, is then placed in a flask on a rotary evaporator, and the solvents stripped off at room temprature. After 2/3 of the volume of solvent has been stripped off the flask should contain a milky suspension of solids (herin referred to as "cud"). This can be filtered off, or the remaining solvent evaporated away to yield a fine, bone white powder. This powder may be mixed with a suitable binder, coated on a support and, when sensitized with $NH_4OH$ fumes, is photosensitive. Alternatively, the acetonitrile solution itself, can also be sprayed on a substrate and dried and exposed to the fumes of $NH_4OH$ to yield a photosensitive film.

EXAMPLE 2

In this example, 2 ml of formic acid are added to 100 ml of reagent grade acetonitrile. This solution is warmed to 100-105°F, and 10 g of technical grade cuprous chloride is added slowly, with stirring. It will dissolve, and form a dark colored liquid. This solution can be sprayed on a substrate to yield a photosensitive coating after sensitization by exposure to the fumes of $NH_4OH$. Alternatively, the cud can be precipitated by pouring the solution into 250 ml of cold toluene. The resulting suspension is placed in a flask on a rotary evaporator, and 200 ml of solvent stripped off. The precipitate slurry is washed 2 times with methanol (100 ml) by resuspending it, allowing it to settle, and decanting. The final washed slurry is stripped to dryness in a rotary evaporator, yielding a fine, bone white powder. It is photosensitive upon exposure to $NH_4OH$ fumes.

EXAMPLE 3

This method of preparation is the simplest. 100 g of technical grade cuprous chloride are placed in a ceramic ball-milling crock with ceramic beads, (3/8" dia.) along with 200 ml of deionized water containing 1% HCl, or 2-5% $SnCl_2$ (stannous chloride). This slurry is then poured off, and allowed to settle out. The aqueous phase is decanted off, and the solids are washed once with 200 ml deionized water (settle, decant) and once with 200 ml methanol (settle, decant). The remaining material is dried under vacuum, yielding a powder which is light-sensitive upon exposure to $NH_2OH$ fumes.

**Claims**

1. A process for preparing highly photosensitive purified copper halide from crude halide material comprising the steps of:
a) aqueous ball-millint of said crude copper halide in the presence of 1-5% by weight of an acid or 1-10% by weight stannous chloride on a percentage basis of crude copper halide to obtain a slurry of fine, uniform particles, to remove impurities therefrom followed removing said water and drying said particles; or, b) dissolving said crude copper halide in acetonitrile in the presence of 1-10% by weight of an acid or stannous chloride on a percentage basis of crude copper halide and recovering fine particles of pure copper halide therefrom; followed by sensitizing said copper halide particles made according to a) or b) by contacting said particles with ammonia. 2. The process of Claim 1 wherein said copper halide is copper chloride. 3. The process of Claim 1 wherein said photosensitive salt is dispersed in a binder and coated on a support to form a photosensitive element. 4. The process of Claim 3 wherein said binder is polyvinyl alcohol. 5. The process of Claim 1 wherein said photosensitive salt is dispersed in a liquid and made into a slurry, said slurry being applied on a support to form a photosensitive element. 6. The process of Claim 5 wherein said liquid is selected from the group consisting of acetonitrile, water, toluene or mixtures thereof. 7. The proces of Claim 3 wherein said coating to form a photosensitive is photosensitized by contact with ammonia fumes. 8. An element made according to the process of Claim 7 wherein said element is imagewise exposed, developed, fixed and dried and said image is enhanced by the application of a conductive material thereon. 9. The element of Claim 8 wherein said image is enhanced by the electroless application of copper thereon.